# DEMANDE DE BREVET EUROPEEN

(11) **EP 0 631 839 A1**
(43) Date de publication de la demande: **04.01.1995**
(21) Numéro de dépôt: 94401432.3
(22) Date de dépôt: 24.06.1994
(51) Int. Cl.: B23K 26/18, B44C 1/02, B41M 5/26

(54) **Procédé de réalisation de structures aluminisées sur un substrat de nitrure d'aluminium**

(30) Priorité: 28.06.1993 FR 9307842
(71) Demandeur: ALCATEL ALSTHOM COMPAGNIE GENERALE D'ELECTRICITE, F-75008 Paris (FR)
(72) Inventeur: Vergnaud, Luc, F-87700 Aixe sur Vienne (FR); Kirmann, Olivier, F-91460 Marcoussis (FR)
(74) Mandataire: Laroche, Danièle

(57) **Abrégé**

La présente invention a pour objet un procédé de réalisation de structures aluminisées sur des zones prédéterminées d'un substrat de nitrure d'aluminium, caractérisé par le fait que lesdites zones sont irradiées par un laser U.V. (10) fonctionnant en mode impulsionnel à une longueur d'onde comprise entre 193nm et 351nm, la densité d'énergie sur lesdites zones étant supérieure ou égale à 500mJ/cm².

La présente invention a également pour objet une structure aluminisée obtenue par le procédé précédent comportant une couche d'aluminium d'épaisseur inférieure à 1µm.

## Description

La présente invention concerne un procédé de réalisation de structures aluminisées sur un substrat de nitrure d'aluminium.

Le substrat de nitrure d'aluminium est une céramique électriquement isolante et bonne conductrice de la chaleur. Un tel substrat a notamment pour fonction de dissiper la chaleur provenant des composants électroniques qu'il supporte. Il est nécessaire de pouvoir réaliser sur ce substrat des structures électriquement conductrices permettant l'interconnexion des différents composants électroniques.

Ces structures peuvent être par exemple des trous, débouchants ou non, de formes diverses (circulaire, rectangulaire, etc...) ou bien des motifs : plots de contact, lignes conductrices, et autres. Les trous par exemple sont d'abord percés puis remplis d'une substance conductrice (laque ou encre conductrice, etc...). Dans le cas des motifs, la surface est préalablement métallisée par dépôt sous vide, puis les motifs sont réalisés par des techniques connues de formation de structures électriquement conductrices.

L'une de ces techniques est la gravure photolithographique décrite par D.M. ALLEN dans son livre: "The principles and practice of photochemical machining and photoetching." (Ed.A.HILGER, Bristol, 1986). Cette méthode consiste à faire apparaître le motif conducteur souhaité en éliminant une résine photosensible après insolation par une lampe U.V. à travers un masque reproduisant ce motif.

L'article de K. OGAWA et al. "Advanced KrF excimer laser lithography for half micron devices" paru en 1988 dans "Laser processes for microelectronic applications." (Electrochem.Soc., Pennington) décrit un perfectionnement de cette méthode appelée photolithographie assistée par laser. Il consiste, pour effectuer l'insolation de la résine, à utiliser une source laser et un système optique projetant le motif souhaité sur le substrat à une échelle réduite.

La technique de gravure photolithographique présentent plusieurs inconvénients. Les opérations sont nombreuses et génèrent des quantité importantes de substances à retraiter, en particulier des solvants. De plus dans le cas d'un trou, l'opération de métallisation est très difficile à réaliser sur les parois et au fond du trou et l'adhérence du dépôt obtenu est médiocre.

Une autre méthode connue est la sérigraphie qui consiste à déposer une encre contenant la substance conductrice en la faisant passer à travers un masque à l'aide d'une raclette. Par cuisson, on obtient le motif conducteur souhaité. Le dépôt effectué par cette méthode est épais (supérieur à 10µm), ce qui rend la métallisation d'un trou de faible diamètre très difficile à réaliser.

La présente invention concerne un procédé de réalisation de structures conductrices, en particulier dans des trous de faibles dimensions, de mise en oeuvre plus facile que les procédé connus et dont les caractéristiques de régularité et d'adhérence de la structure conductrice obtenue sont améliorées.

L'objet de la présente invention est un procédé de réalisation de structures aluminisées sur des zones prédéterminées d'un substrat de nitrure d'aluminium. Ces zones sont irradiées par un laser U.V. fonctionnant en mode impulsionnel à une longueur d'onde comprise entre 193nm et 351nm, la densité d'énergie sur les zones étant supérieure ou égale à 500mJ/cm². Le maximum de densité d'énergie n'est limitée que par le type de laser utilisé.

Lorsque la densité d'énergie sur le nitrure d'aluminium atteint 500mJ/cm², l'aluminium et l'azote contenus dans le matériau s'évaporent. Puis l'aluminium se recondense sur la surface pour créer une couche électriquement conductrice dans la zone d'interaction faisceau U.V.-nitrure d'aluminium limitée par l'image réduite d'un masque représentant la structure à réaliser. Bien qu'il ne soit pas indispensable, le masque a pour avantage de permettre d'une part la réalisation plus rapide de motifs complexes, et d'autres part l'obtention de motifs à bords francs en limitant le faisceau à son domaine le plus énergétique.

L'irradiation est réalisée de préférence en atmosphère non oxydante bien qu'une structure électriquement conductrice puisse être obtenue à l'air ambiant. En présence d'oxygène, l'aluminium risque de former de l'alumine en surface ce qui diminue la qualité du dépôt.

Selon une variante préférentielle de mise en oeuvre du procédé, l'irradiation est effectuée sous vide.

Selon une autre variante de mise en oeuvre du procédé, l'irradiation est effectuée sous gaz neutre, comme l'argon ou l'hélium.

La fréquence de répétition des impacts du laser dépend de la source utilisée, par exemple 1Hz à 250Hz, mais des fréquences supérieures à 250Hz permettent aussi la formation d'une couche électriquement conductrice. La vitesse de déplacement du faisceau dépend directement de cette fréquence.

De préférence, la vitesse de déplacement dudit laser est choisie de telle sorte que le taux de recouvrement des impacts soit supérieur à 10%. Pour la formation de lignes conductrices, il faut que les impacts successifs se chevauchent pour qu'il y ait continuité dans le motif.

Le procédé selon la présente invention a pour avantage de permettre de réaliser une structure aluminisée en une seule opération. Le procédé ne nécessite pas l'ajout de produits; il ne produit pas de dégagement de gaz nocifs ni de déchets (solvant, acide, ...) à retraiter, ce qui le rend particulièrement économique.

La présente invention a également pour objet une structure aluminisée obtenue par ce procédé, comportant une couche d'aluminium d'épaisseur inférieure à 1µm, en général de l'ordre de quelques dixièmes de microns.

Selon une variante de réalisation, la structure aluminisée a la forme d'un trou de diamètre compris entre 1µm et 1mm. Le procédé permet de réaliser des trous, débouchants ou non et électriquement conducteurs dans lesquels une couche d'aluminium est régulièrement déposée sur les parois et le fond du trou percé par le laser. La couche d'aluminium ainsi formée peut servir directement de couche électriquement conductrice et ainsi recevoir des composants électroniques.

Selon une autre variante de réalisation, la structure aluminisée est en outre recouverte d'un dépôt de métal électrolytique. Si le métal requis n'est pas l'aluminium, les surfaces aluminisées se comporteront comme des surfaces activées sur lesquels un dépôt électrolytique se fera préférentiellement.

Le principal avantage de la structure aluminisée réalisée selon le présent procédé est que la couche d'aluminium ainsi constituée a une excellente adhérence qui ne peut pas être obtenue avec les procédés connus. De plus par ce procédé il est possible de réaliser une structure aluminisée complexe avec une précision dans la dimension du motif de l'ordre de 1%.

D'autres caractéristiques et avantages de la présente invention apparaitront au cours de la description et à la lecture des exemples suivants de modes de réalisation, donnés bien entendu à titre illustratif et non limitatif, et dans le dessin annexé dans lequel:
- la figure 1 montre schématiquement le procédé de l'art antérieur,
- la figure 2, analogue à la figure 1, donne une variante du procédé de l'art antérieur,
- la figure 3 représente le procédé selon la présente invention.

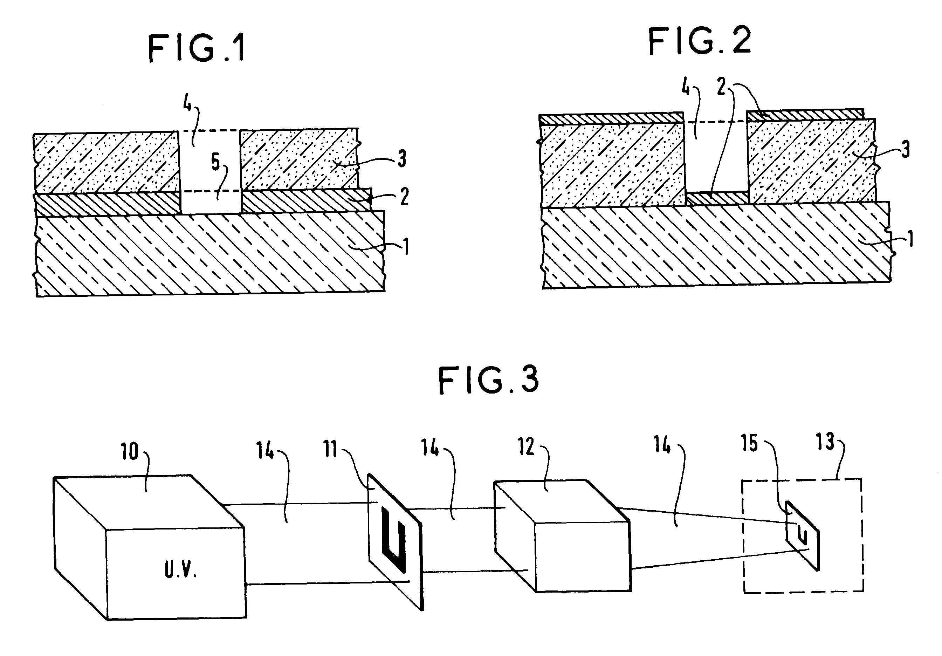

Selon l'art antérieur, l'une des techniques habituellement employée est la gravure photolithographique. Cette méthode représentée par la figure 1 consiste à déposer d'abord par évaporation une substance conductrice 2 (or, argent, cuivre, ...) sur le substrat 1, puis l'ensemble est recouvert d'une résine photosensible 3. On procède alors à l'insolation de la résine par une lampe U.V. à travers un masque représentant le négatif du motif à l'échelle 1. La résine insolée 4 est ensuite enlevée par rinçage, et dans cette zone la partie 5 du film conducteur devenue apparente est éliminée par dissolution chimique. Enfin le rinçage du substrat permet d'enlever la résine restante en laissant apparaître le motif conducteur souhaité.

Une variante de cette méthode représentée sur la figure 2 consiste à déposer en premier lieu la résine 3 qui est insolée à travers un masque. Après élimination de la résine insolée 4, la substance conductrice 2 est déposée par évaporation. Un dernier rinçage enlève la résine restante en laissant apparaître le motif conducteur souhaité.

L'installation de réalisation de structures aluminisées sur un substrat de nitrure d'aluminium selon la présente invention est schématisée sur la figure 3. La réalisation de ces structures électriquement conductrices nécessite l'emploi d'un laser U.V. 10 fonctionnant en mode impulsionnel à une longueur d'onde comprise entre 193nm et 351nm, d'un masque 11 représentant un agrandissement de la structure à réaliser, d'un système optique 12 de projection du masque 11, et d'une enceinte 13 pour travailler en atmosphère controlée. Le faisceau laser 14 transporté par un jeu de miroirs atteint le masque 11. La partie du faisceau diaphragmée est traitée par le système optique 12 qui reconstruit l'image du masque 11 sur le substrat 15 de nitrure d'aluminium à une échelle réduite, d'un facteur 2 à 200, qui dépend du réglage du système optique 12. Le motif à réaliser se trouve projeté à l'échelle 1 sur le substrat 15.

### EXEMPLE 1

Une installation analogue à celle décrite précédemment mais ne comportant pas de masque est utilisée pour la réalisation d'une ligne conductrice sur un substrat de nitrure d'aluminium. L'irradiation est effectuée sous atmosphère neutre, le substrat étant placé sous argon. Le laser employé délivre une fréquence d'impulsions de l'ordre de 100Hz, ce qui permet une vitesse linéaire de traitement du substrat de 60mm/mn tout en préservant la continuité du motif. La densité d'énergie atteinte sur les zones irradiées est de 10J/cm². L'épaisseur de la couche d'aluminium est d'environ 0,5µm. La ligne conductrice obtenue est caractérisée par sa résistance qui est de 30Ω/cm.

### EXEMPLE 2

Une installation analogue à celle décrite précédemment mais comportant un masque représentant un disque est utilisée pour la réalisation d'un trou circulaire métallisé sur un substrat de nitrure d'aluminium. L'irradiation est effectuée à l'air ambiant. Le laser employé délivre une fréquence d'impulsions de l'ordre de 10Hz, ce qui permet une vitesse d'ablation du substrat de 25µm/mn. La densité d'énergie atteinte sur les zones irradiées est de 13J/cm². L'épaisseur de la couche d'aluminium est d'environ 0,5µm. Le trou métallisé obtenu a un diamètre d'environ 250µm. Il est caractérisée par sa résistance qui est de 100Ω/cm.

Bien entendu la présente invention n'est pas limitée aux modes de réalisation décrits et représentés, mais elle est suceptible de nombreuses variantes accessibles à l'homme de l'art sans que l'on ne s'écarte de l'esprit de l'invention.

## Revendications

**1./** Procédé de réalisation de structures aluminisées sur des zones prédéterminées d'un substrat de nitrure d'aluminium, caractérisé par le fait que lesdites zones sont irradiées par un laser U.V. fonctionnant en mode impulsionnel à une longueur d'onde comprise entre 193nm et 351nm, la densité d'énergie sur lesdites zones étant supérieure ou égale à 500mJ/cm².

**2./** Procédé selon la revendication 1, caractérisé par le fait que l'irradiation est effectuée sous vide.

**3./** Procédé selon la revendication 1, caractérisé par le fait que l'irradiation est effectuée sous gaz neutre.

**4./** Procédé selon l'une des revendications précédentes, caractérisé par le fait que la vitesse de déplacement dudit laser est choisie de telle sorte que le taux de recouvrement des impacts soit supérieur à 10%.

**5./** Structure aluminisée obtenue par le procédé selon l'une des revendications précédentes, caractérisée par le fait que ladite structure comporte une couche d'aluminium d'épaisseur inférieure à 1µm.

**6./** Structure aluminisée obtenue par le procédé selon l'une des revendications précédentes, caractérisée par le fait que ladite structure a la forme d'un trou de diamètre compris entre 1µm et 1mm.

**7./** Structure aluminisée obtenue par le procédé selon l'une des revendications précédentes, caractérisée par le fait que ladite structure est en outre recouverte d'un dépôt de métal électrolytique.
